**Europäisches Patentamt**

**European Patent Office**

**Office européen des brevets**

(19)

(11) **EP 1 422 822 A2**

(12) **EUROPEAN PATENT APPLICATION**

(43) Date of publication:
26.05.2004 Bulletin 2004/22

(51) Int Cl.⁷: **H03C 3/09**

(21) Application number: **03103740.1**

(22) Date of filing: **09.10.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | • **Shimon, Guy**<br>**67899 Tel Aviv (IL)**<br>• **Shamsian, Roni**<br>**67899 Tel Aviv (IL)** |
| (30) Priority: **19.10.2002 GB 0224352** | (74) Representative: **McCormack, Derek James**<br>**Motorola**<br>**European Intellectual Property Operations**<br>**Midpoint** |
| (71) Applicant: **MOTOROLA, INC.**<br>**Schaumburg, IL 60196 (US)** | **Alencon Link**<br>**Basingstoke Hampshire RG21 7PL (GB)** |
| (72) Inventors:<br>• **Corse, Nir**<br>**67899 Tel Aviv (IL)** | |

(54) **Frequency generation in a wireless communication unit**

(57) A wireless communication unit (400) comprises a dual-port modulator for generating a radio frequency signal. A digital to analogue converter (446), operably coupled to a data generator (570), converts digital data to an analogue signal to be used in generating the radio frequency signal. An attenuator (450), operably coupled to the digital to analogue converter (446) attenuates the analogue signal output from the digital to analogue converter (446). A signal processor (402) is operably cou-

pled to the attenuator (450) for setting an attenuation value of the attenuator (450) to balance signals input to the two ports of the dual-port modulator.

This enables the wireless communication unit to balance levels of the dual-port and direct-port signals thereby minimising phase error RMS and phase error peaks in the generated frequency signal. Cheaper reference oscillators with less accurancy components may then be used, as the arrangement and method automatically compensate for any mismatch between the ports.

*FIG. 5*

EP 1 422 822 A2

**Description**

**Field of the Invention**

This invention relates to frequency generation circuits for wireless communication units. The invention is applicable to, but not limited to, a frequency generation circuit that needs to function with a low phase noise.

**Background of the Invention**

Wireless communication units, for example those operating in a cellular telephone system such as the Global System for Mobile communications (GSM), use a broadcast reference frequency signal to calibrate their operating (transmit/receive) frequency. The broadcast signal is generally transmit from one or more base transceiver stations (BTSs). In this manner, the wireless communication units use the broadcast reference frequency signal in order to synchronise their internal frequency generation circuits. The units synchronise their operating frequency to match the system frequency, prior to entering into a communication. The synchronisation occurs when receiving a signal and when generating a modulated signal for transmission.

The GSM standard specifies a modulation scheme of Gaussian Minimum Shift Keyed (GMSK). Such a minimum shift keying (MSK) modulation scheme is a subset of a frequency shift-keying scheme (FSK). In FSK, binary data is communicated by switching between two frequencies, where one frequency is sent if a current data bit is a '1' and a second frequency is sent if a current data bit is a '0'. When the frequency deviation is set to equal half the input serial baud rate, the modulation scheme is termed MSK.

There are many known techniques for synthesizing modulated signals onto frequencies for transmission. A popular technique at present is using a fractional division synthesizer, which enables a wide range of discrete frequencies to be tuned to by appropriate selection of 'division' parameters applied to a reference oscillator.

The GSM standard also specifies a data rate of 270 kbits/sec in the transmission of speech and data signals. To facilitate such large data rate, a large synthesizer loop bandwidth is required. A problem in using a fractional division synthesizer is that it is invariably not wide enough to cover the entire modulation frequency for both low and high frequency response in order to handle the GMSK modulation requirements. With a typical loop bandwidth of less than 200 kHz, the synthesizer bandwidth is less than the modulation bandwidth. In essence, it is therefore a narrow bandwidth synthesizer.

Modulating a signal to a single port, to give a uniform performance for the entire GMSK bandwidth is known to be a complex task. Alternatively, the synthesizer can be divided into two portions, a low frequency response of the synthesizer and a high frequency response of the VCO that rolls off at the loop bandwidth.

One of the most commonly used techniques to enable fractional division synthesizers to be used in synthesizing high data rate signals is to use a two spot modulation technique. This technique applies Modulation to both the synthesizer loop and the voltage-controlled oscillator (VCO), as known to those skilled in the art. In this design, the modulation signal is applied to the loop divider and the VCO tuning (steering) line, or loop filter.

The loop divider is sensitive only to the signal frequencies below the loop bandwidth. The VCO is sensitive only to signal frequencies above the loop bandwidth. Thus, at around the loop bandwidth the modulation signal is sensitive to both the loop divider as well as the VCO, where the resultant response of the modulation signal is the sum of the VCO response and the loop response.

Low frequency modulation is applied to the loop divider rather than the more conventional method of phase modulation to facilitate digital modulation. The digital modulation method allows for very low frequency modulation, down to DC level, which is normally not possible with the well-known reference modulation method. Modulation frequencies above the loop bandwidth of 150 kHz must be applied to the VCO for FM modulation. Typically, the high frequency components of the GMSK modulating signal are applied to the VCO via an on chip programmable attenuator. The output of the modulation attenuator is applied to the VCO modulation port.

In a GMSK modulator, the input signal is differentially encoded and mapped to '+1' or '-1' in a frequency shift keyed manner and pre-filtered with a digital Gaussian filter, to reduce the distortion resulting from the bit transitions and produce a GMSK modulated signal. The filtering may be performed using a read-only memory (ROM) look up filter. When applied in a dual-port modulator technique, the filtered signal is then used to modulate a fractional 'N' synthesizer (Direct Port), where it is filtered again by the synthesizer closed loop response, as known to those skilled in the art.

It is also known that the filtered signal may be routed to an analogue to digital converter (A/D). The A/D output is then attenuated and passed to the voltage controlled oscillator (VCO) steering line. The signal from the dual-port is filtered by high pass filter. Combining both signals, from the dual-port and the direct port, yields the desired GMSK signal.

A significant advantage of a dual-port technique is the ability to establish low phase noise at the synthesizer level. The level of phase noise is typically of the order of -121 dBc/Hz @ 400 kHz away from the centre frequency. In this regard, phase detector noise must be attenuated. The phase noise is thus attenuated whilst preserving a high quality generated GMSK signal in terms of root mean square (RMS) phase error. A typical phase error RMS value is approximately 1.1 degrees.

A key factor in the design of a dual-port modulator is in obtaining a flat modulation response from DC to 300 kHz. In this regard, it is important to select how and where the modulation signal is applied to the VCO.

One known method is to apply the modulation signal directly to the VCO steering line via a small capacitor. This method has the problem of unbalanced zeroes and poles due to the loop filter. As such, it requires a separate, undesirable pole/zero cancellation network to achieve modulation flatness.

Another method is to apply the modulation signal to a loop filter via a resistive voltage divider. This method should give a flat modulation response without a pole/zero compensation network. However, this implementation requires a coupling capacitor to provide for direct current (DC) blocking from the modulation attenuator buffer output. This DC blocking capacitor has the potential problem of introducing undesirable DC transients on very low frequency components. Also, the resistive divider potentially provides a leakage path for the loop capacitor to cause an apparent increase in synthesizer settling time.

An alternative method is to use a capacitive attenuator network to couple the modulating signal into the loop filter.

However, the inventors of the present invention have recognised a number of disadvantages with such a dual-port modulator technique. In particular, in order to minimise phase error RMS and peak phase error of the transmitted signal, it is critical that attenuation balancing is performed between the direct port and the dual-port of the dual-port modulation input.

The current technique to achieve balancing of the dual-port signals is to measure the VCO RMS during factory tuning and manually tune the VCO sensitivity response. This is a very time-consuming exercise. It is also an inflexible solution as, once tuned, there is no mechanism for re-tuning apart from returning the unit to the factory.

A primary focus of the present invention was to produce a GSM transmitter that is based on dual-port modulation and a capacitance divider arrangement for coupling the input signal to the modulator. To maintain low cost, the transmitter needs to generate with a reduced voltage controlled oscillator (VCO) sensitivity specification in terms of component tolerances, (i.e. $K_V$ Min/$K_V$ Max = 20% ~ 30 %), in order to facilitate a simple and inexpensive transmitter design.

Thus, a need has arisen to provide a wireless communication unit, and in particular, a method of selecting and controlling appropriate attenuation values in a VCO dual-port modulation circuit, wherein the aforementioned disadvantages may at least be alleviated.

**Statement of Invention**

In accordance with a first aspect of the present invention, there is provided a wireless communication unit, as claimed in Claim 1.

In accordance with a second aspect of the present invention there is provided a method of tuning a frequency of a wireless communication unit, as claimed in Claim 6.

In accordance with a third aspect of the present invention, there is provided a storage medium storing processor implementable instructions or associated data, as claimed in Claim 11.

Further aspects of the present invention are defined in the dependent Claims.

**Brief Description of the Drawings**

Exemplary embodiments of the present invention will now be described, with reference to the accompanying drawings, in which:

FIG. 1 illustrates constellations of phase error of a GMSK signal versus attenuation mismatch in a dual-port modulator;

FIG. 2 illustrates a graph of total transfer magnitude of a GMSK signal versus attenuation mismatch in a dual-port modulator;

FIG. 3 illustrates a graph of GMSK phase error RMS and peak phase error versus attenuation mismatch in a dual-port modulator;

FIG. 4 shows a block diagram of a wireless communication unit adapted to support the various inventive concepts of the present invention;

FIG. 5 shows a block diagram of a dual-port modulator arrangement adapted to support the various inventive concepts of a preferred embodiment of the present invention;

FIG. 6 shows a flowchart of the dual-port attenuation balancing process in accordance with the preferred embodiment of the present invention;

FIG. 7 shows a graph of VCO sensitivity versus estimated VCO sensitivity when applying the dual-port attenuation balancing process of the preferred embodiment of the present invention; and

FIG. 8 shows a graph of phase error RMS versus attenuator settings across a range of transmitter channels when applying the dual-port attenuation balancing process of the preferred embodiment of the present invention.

## Description of Preferred Embodiments

In the context of the present invention, the inventors determined that attenuation/level balancing in a dual-port modulator depends on the following characteristics:

(i) The VCO sensitivity;
(ii) Loop filter component tolerances; and
(iii) Internal attenuation tolerances.

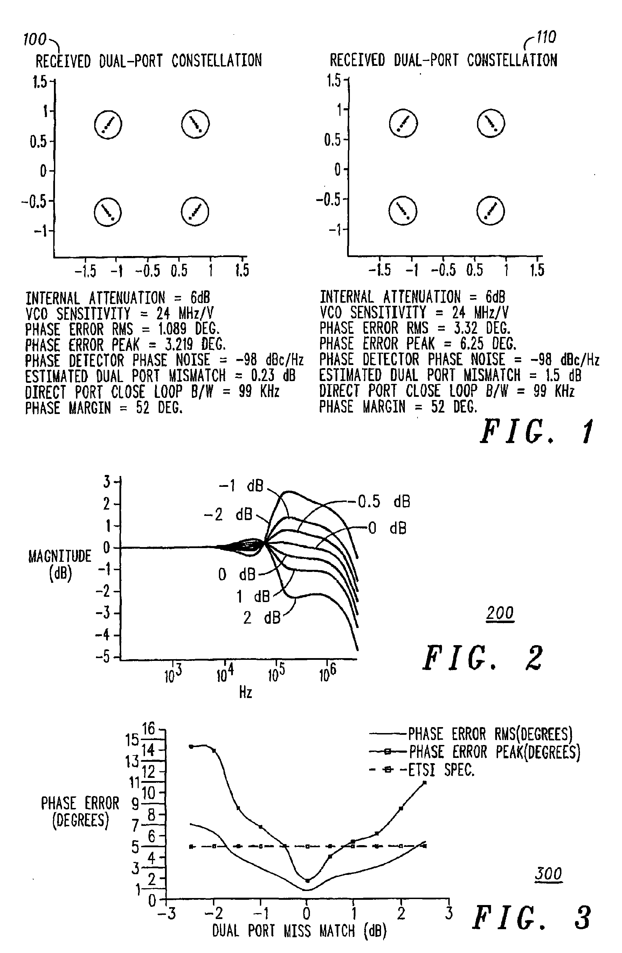

In order to quantify the sensitivity requirements of a dual-port modulator, simulations were performed to determine the VCO's phase error RMS sensitivity to dual-port balancing/mismatching. It was determined that a +/-2dB difference between the ports resulted in a phase error RMS of approximately five degrees. The effect of dual-port balancing/mismatch sensitivity on phase error margin variation on the balancing was then estimated. The results are indicated in FIG. 1, where graphs of received dual-port constellations are illustrated. A first graph 100 indicates the simulated phase error mismatch of 0.23dB compared to a simulated phase error mismatch of 1.5dB in the second graph 110. As shown in the second graph 110, a mismatch of 1.5 dB is acceptable.

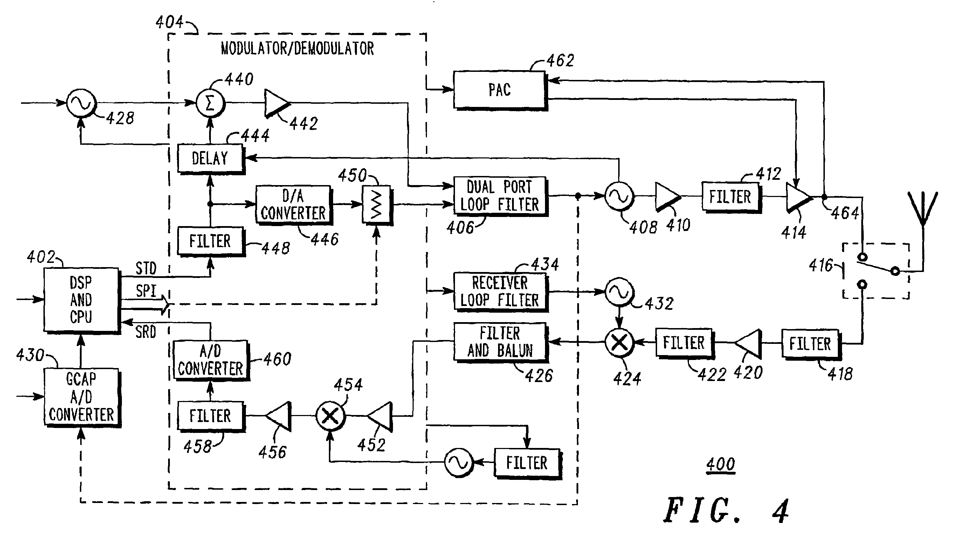

Referring now to FIG. 2, the effect of the transmitted signal quality in terms of phase error RMS and peak is illustrated. In particular, a range of closed loop responses are shown for various mismatches (in dB), plotted against the total transfer function magnitude. As shown, a mismatch of approximately 1.5dB causes a peak phase error of approximately 2dB and a phase error RMS performance of approximately 1dB. FIG. 2 illustrates clearly, why dual port balancing is required. Any mismatch in the dual-port levels will result in an undesired close loop response, which will cause phase error RMS degradation. Thus, the inventors of the present invention have determined that balancing is required on the DAC output. This balancing is effected in the form of Voltage Attenuation, using an attenuator, the operation of which is described later with regard to FIG. 4, FIG. 5 and FIG. 6. The amount of attenuation required, i.e. the level of balancing to counteract the mismatch, is dependent upon the phase error RMS.

Referring now to FIG.3, a graph illustrates the estimated phase error RMS and peak phase error versus dual-port mismatch. It is clear from FIG. 3 that in order to maintain sufficient GMSK signal quality in terms of phase error, a worst-case dual-port mismatch of +/- 1.5dB is desired. It is notable that the phase error RMS and peak phase error is not symmetric dependent upon the level of dual-port attenuation mismatch. Furthermore, it is noted that increasing the phase margin will result in improved attenuation mismatch sensitivity.

VCO sensitivity and loop tolerances can cause undesired mismatch, as shown in equation [22] below. It is important to estimate the amount of dual-port balancing that will still insure desired phase error RMS and phase error peak. The mismatch sensitivity is related to the phase margin and the closed loop bandwidth of the direct port. Those parameters need to be carefully controlled in order to achieve the desired adjacent channel phase noise performance.

It was further determined by the inventors that by increasing the VCO's loop phase margin from fifty degrees to approximately sixty degrees, resulted in an improvement in the balancing margin of approximately 2dB and approximately five degrees of phase error RMS. Furthermore, increasing the phase margin resulted in a decreased adjacent channel power (ACP) performance of 3dB at 400 kHz from the centre frequency, i.e. -70dB to -67dB. From these calculations, it can be determined that it is necessary to lower the (worst-case) sensitivity mismatch to approximately +/- 1dB. The inventors of the present invention also determined that the total attenuation required in order to achieve balancing is -43.03 dB, for a typical VCO sensitivity of 24 MHz/V.

A major factor in such VCO designs is the use of low tolerance components to keep costs low. For example, it is typical for manufacturers to design VCO circuits with transmit VCO sensitivity tolerances of around 20% with loop filter component tolerances of 5%. Thus, with such tolerance values, the inventors of the present invention determined that the worst-case attenuation mismatch could be +/-3.2dB in terms of phase error RMS and adjacent channel power (ACP). It is therefore clear that using typical tolerance values for the loop filter components is insufficient to achieve the required sensitivity performance in a dual-port modulation scheme.

Thus, the inventors of the present invention have developed the following equation in order to set the desired attenuation/magnitude in the dual-port modulator:

$$\text{Internal Atten. [dB] + Capacitance Divider Attenuation}$$

$$\text{[dB] = F (VCO Sensitivity, D/A Output Voltage)} \qquad [1]$$

By simulating a dual-port modulator, it was determined that the capacitance divider attenuation needs to be -36.8dB. The total desired attenuation could be estimated for specific VCO sensitivity values. Table 1 presents the total desired attenuation versus a typical VCO of 24 MHz/V for different sensitivity tolerances.

Table 1:

| Total desired attenuation versus sensitivity tolerance | | | |
|---|---|---|---|
| VCO SENSITIVITY TOLERANCES % | MIN TOTAL ATTENUATION [DB] | MAX TOTAL ATTENUATION [DB] | VCO SENSITIVITY MARGIN [MHZ/V] |
| 1 | -42.945 | -43.119 | +/- 0.24 |
| 2 | -42.857 | -43.204 | +/- 0.48 |
| 3 | -42.76 | -43.303 | +/- 0.72 |
| 4 | -42.678 | -43.37 | +/- 0.92 |
| 5 | -42.587 | -43.456 | +/-1.2 |
| 10 | -42.117 | -43.86 | +/- 2.4 |
| 20 | -41.094 | -44.616 | +/- 4.8 |

Table 2:

| Capacitance divider attenuation, versus loop filter component tolerances. | | |
|---|---|---|
| LOOP FILTER COMPONENTS TOLERANCES % | MIN ATTENUATION [DB] | MAX ATTENUATION [DB] |
| 2 | -36.46 | -37.14 |
| 5 | -35.95 | -37.66 |

Returning to equation [1], for capacitance divider attenuations, results in the following definitions:

$$\text{Max. atten. = Max. Total atten. - Min. CA} \qquad [2]$$

$$\text{Min. atten. = Min. Total atten. - Max. CA} \qquad [3]$$

$$\text{Effective Mismatch = Max. atten. - Min. atten.} \qquad [4]$$

Where:

$$\text{CA = Capacitance Attenuation [dB]}$$

Table 3:

| Effective Maximum Mismatch [dB] | | | |
|---|---|---|---|
| TOLERANCE [LOOP FILTER, VCO SENSITIVITY] | MAX. INTERNAL ATTENUATION [DB] | MIN. INTERNAL ATTENUATION [DB] | EFFECTIVE MISMATCH [DB] |
| [5%, 5%] | -7.51 | -4.927 | +/- 1.3 |
| [2%, 5%] | -6.996 | -5.44 | +/- 0.78 |

From Table 3, it can be clearly seen that using capacitance divider loop filter components with tolerances of 2%, together with a VCO sensitivity of 5%, results in an effective attenuation mismatch of +/- 0.78 dB. The inventors of the present invention determined that this level of performance, when used in conjunction with a VCO sensitivity/ tuning algorithm, is sufficient for the dual-port modulator. Thus, the VCO sensitivity/tuning algorithm focus is to monitor the VCO sensitivity to within +/- 1 MHz/V.

Referring now to FIG. 4, a block diagram of a wireless subscriber communication unit/mobile station (MS) 400, adapted to support the inventive concepts of the preferred embodiments of the present invention, is illustrated. The wireless communication unit 400 includes a digital signal processor (DSP) 402 that transmits '0's/'1's binary data via a line identified by 'STD', and receives '0's/'1's binary data via a line identified by 'SRD'. The DSP 402 inputs binary data to a radio frequency (RF) modulator/demodulator (MODEM) function 404.

In a transmit (TX) mode of operation, the RF MODEM 404 is used for synthesizing the GMSK signal and modulating the TX VCO. In a receive (RX) mode of operation, the RF MODEM 404 is used for back-end demodulation.

The RF MODEM 404 outputs a synthesized GMSK signal to a dual-port loop filter 406. This filter is used for both a direct-port and a dual-port of the VCO design of the present invention, i.e. the direct port uses an 'up'. (high-frequency response) pin, and the dual-port uses a 'down' (low-frequency response) pin. The dual-port loop filter 406 outputs a filtered signal to a TX VCO circuit 402. The TX VCO circuit 402 is modulated to the desired RF frequency, using the direct and dual port directly. The TX VCO circuit 402 is fed to a driver function 410, which is a first stage amplifier and buffer used for TX VCO isolation. The driver function 410 outputs a signal to a filter 412 that filters harmonics, and thereafter to the RF power amplifier (PA) 414. The RF PA is the main RF power amplifier used to achieve the desired output signal power. The high-power RF signal is fed to a coupler 464 that couples the RF signal to the power amplifier control (PAC) 462 for control analysis. The PAC 462 controls the power level and the time ramp-up and ramp-down of the transmitted signal. The high-power RF signal is input to an antenna switch 416, which performs the RF switching between TX and RX modes of operation for time division multiplexing.

In a RX mode of operation, a received signal is routed from the antenna switch 416 to a Front-end Filter 418. The Front-end Filter 418 is the first RF stage in the receiver and filters the image and half-IF spurs, as known to those skilled in the art. The front-end filtered signal is input to a Low Noise Amplifier (LNA) 420, where it is amplified and input to a Mixer 424 that translates the received frequency to an intermediate frequency (IF). The IF signal is input to a filter and balun 426, which is used for IF filtering and filtering the received channel, as known to those skilled in the art.

With regard to the frequency generation and control circuitry, a reference local oscillator (TCXO) 428 is used for the RF and Digital circuits. An analogue to digital converter function (GCAP A/D) 430 is used for sampling the TX VCO sensitivity for dual port processing, in accordance with the preferred embodiment of the present invention. A low-noise local oscillator (RX VCO) 432 is configured to operate at an IF frequency above the received frequency band. In a GSM unit, this is typically arranged to be a frequency of 26 MHz. A RX loop filter 434 is used for the main RX loop dynamics and filtering spurs and noise. In a GSM unit, this is typically configured to be 60 KHz in order to achieve the necessary lock time. A second local oscillator (LO) VCO 236 is used translate the IF frequency to base band at mixer 454, after the received filtered signal has been amplified by pre-amplifier 452. The pre-amplifier introduces high gain to the received signal in order to achieve the desired dynamic range. A second LO loop filter 438 ensures that a single-tone oscillator signal appears in the IF frequency. The received base band signal output from mixer 454 is amplified in base band amplifier 456 and filtered in base band filter 458, before being sampled in the receiver analogue-to-digital converter (RX A/D) 460, to produce a digital received signal for processing by DSP 402.

A phase detector 440 in the RF MODEM 404 detects the phase difference between the divided TX VCO 402 and the TCXO 428 reference signal. A charge pump 442 introduces current into, or out of, the loop filter 406, in proportion to the detected phase difference. A loop divider 444 divides the frequency from the TX VCO 402 to match the reference signal frequency.

In particular, in accordance with the preferred embodiment of the present invention, a dual-port digital to analogue (D/A) converter 446 converts the digital filtered signal to an analogue signal, in order to modulate the TX VCO signal using the dual port. The dual-port digital signal has been pre-filtered by GMSK filter 448, with a bandwidth

**EP 1 422 822 A2**

of BT = 0.3. This ensures that differential encoding, mapping and filtering is performed.

Notably, in accordance with the preferred embodiment of the present invention, a dual-port attenuator 450 is used for amplitude balancing between the direct port and dual-port. The DSP 402 controls the attenuator value.

In accordance with a preferred embodiment of the present invention, the frequency generation circuitry has been adapted so that it is able to use low tolerance components. Furthermore, the DSP 402 performs an attenuation-tuning algorithm. In this manner, the two output signals from the dual-port modulator are substantially balanced, as attenuator 450 controls the dual-port signal level.

Clearly, for other wireless communication products, other circuit configurations may be used. Furthermore, a skilled artisan will appreciate that the DSP 402 may be located in a different position and function in a different manner to that shown.

The DSP 402 has also been adapted to include a look-up table that stores attenuator settings to be used to attenuate DAC output signals. Preferably, the look-up table stores attenuator settings for distinct transmitter channel frequency ranges for the wireless communication unit 400, as shown in Table 3 below. In this manner, the DSP 402 selects an attenuator setting to ensure a balanced output from the dual-port modulator based upon a frequency or frequency range used by the transmitter.

Of course, the various components within the wireless communication unit 400 may be realised in discrete or integrated component form. Furthermore, it is within the contemplation of the invention that the wireless communication unit 400 may be any wireless communication device, such as a portable or mobile PMR radio, a mobile phone, a personal digital assistant, a wireless laptop computer, etc.

More generally, any re-programming or adaptation of one or more software algorithms or data banks of the DSP 402, may be implemented in any suitable manner. For example, a new signal processor function or memory device may be added to a conventional wireless communication unit 400. Alternatively, existing parts of a conventional wireless communication unit may be adapted, for example by reprogramming one or more processors therein. As such, the required adaptation may be implemented in the form of processor-implementable instructions stored on a storage medium, such as a floppy disk, hard disk, PROM, RAM or any combination of these or other storage multimedia.

The preferred embodiment of the present invention is described with reference to the GSM standard. However, it is within the contemplation of the invention that the inventive concepts described herein equally apply to any wireless communication system.

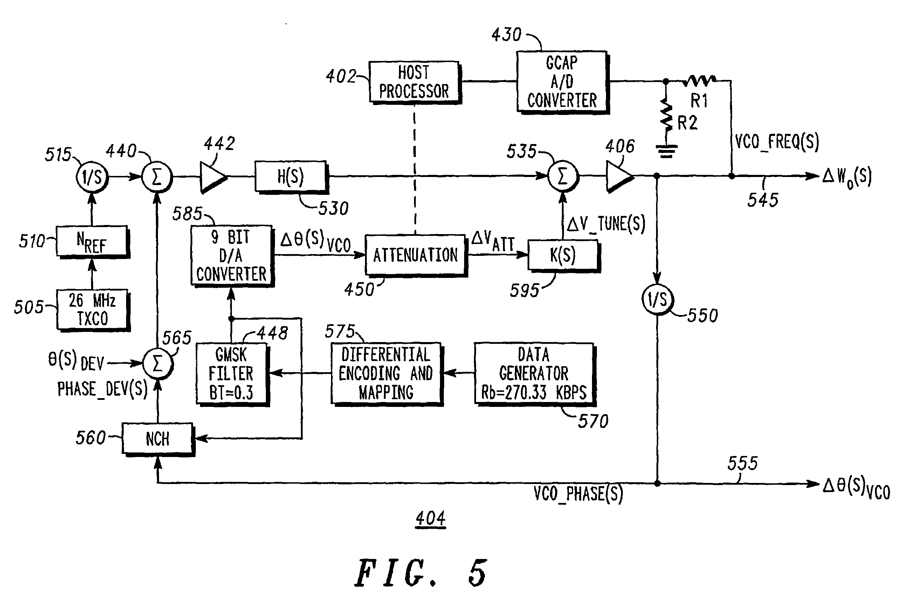

Referring now to FIG. 5, the dual-port modulator 404 adapted in accordance with the preferred embodiment of the present invention is shown in greater detail. In the dual-port modulator 404, binary input data is generated by data generator 570 in a series of '0's and '1's. This input data is differentially encoded and mapped 565 to '+1' or '-1' in a frequency shift keyed manner, prior to digital Gaussian filtering 448 with a 3dB bandwidth of BT=0.3, as known to those skilled in the art.

The filtered signal is then used to modulate a signal generated by a fractional synthesizer (505, 510, 515) input to the Direct Port, where it is filtered again by the synthesizer close loop response, as known to those skilled in the art. In order to achieve the desired phase noise at the synthesizer output, the phase detector noise must be attenuated. This causes the GMSK signal to be high frequency filtered. The filtered GMSK signal can be compensated using a 'Dual-port' high pass filter 406.

It is envisaged that the filtered signal may also be routed to an analogue to digital converter (A/D). The A/D output is attenuated and passed to the voltage controlled oscillator (VCO) steering line. A high-pass filter filters the signal from the dual-port. Combining both signals form the dual-port and the direct port yields the desired GMSK signal. An analogue to digital converter (A/D) 430 is used to sample the voltage at the VCO steering line, while changing the transmitted channel. The A/D 430 is operably coupled to a host microprocessor, for example DSP 402 of FIG. 4, so that the sampled values can be processed and attenuator values stored in memory. As the transmit channel of the wireless communication unit is known at any point in time, the VCO sensitivity for that channel can be estimated. During factory set-up of the wireless communication unit, the desired attenuation for each of the transmit channels is calculated. This information is preferably stored in a memory element operably coupled to DSP 402 as an array indicating variable attenuator values. A preferred list of suitable attenuator values is illustrated in Table 3.

The synthesized GMSK signal is passed through a 9-bit DAC 446. Notably, in accordance with the preferred embodiment of the present invention, the DAC output signal is attenuated using the variable attenuator 450. This signal is convolved with the dual-port closed loop transfer function 530, namely H(s) = Wvco/Vdac.

Thus, in FIG. 5, the two close loop transfer functions (Direct and Dual) are estimated. The amplitude balance between the two functions can be achieved using equation [21], as explained below. The following set of equations is included to indicate to a skilled artisan the theory behind the dual-port modulator of the preferred embodiment of the present invention.

A superposition model is used to estimate the balance criteria, in terms of the desired attenuation, delay and phase response.

Note: $K_0$ - is the VCO Sensitivity [MHz/V]

$I_{CP}$ - is the charge pump current [mA]

$$K_V = 2\pi K_0 \qquad [5]$$

$$K_\phi = \frac{I_{CP}}{2\pi} \qquad [6]$$

$$\frac{\Delta\Theta_{VCO1}|S|}{\Delta\Theta_{dev}|S|} = \Psi_1(S) \Rightarrow S\Delta\Theta_{VCO1}(S) = \Psi_1(S)\cdot S\Delta\Theta_{dev}(S) \qquad [7]$$

$$\Delta\omega_{VCO1} = 2\pi\Psi_1(S)\cdot\Delta f_{dev}(S) \qquad [8]$$

$$\frac{\Delta\Theta_{VCO2}|S|}{\Delta V\_TUNE|S|} = \Psi_2|S| \qquad [9]$$

$$\frac{\Delta V\_TUNE|S|}{\Delta V_{ATT}|S|} = K|S| \qquad [10]$$

$$\frac{\Delta V_{ATT}}{\Delta V_{DAC}} = ATT \qquad [11]$$

$$\Delta\Theta_{VCO2}(S) = \Psi_2(S)\cdot K(S)\cdot ATT\cdot\Delta V_{DAC}(S) \qquad [12]$$

$$\frac{\Delta\Theta_{VCO1}|S|}{\Delta\Theta_{dev}|S|} = \psi_1(S) = -\frac{\beta|S|A_{OL}|S|N_{ch}}{1 + \beta|S|A_{OL}|S|} \qquad [13]$$

Where :

$$\beta(S)A_{OL}(S) = \frac{K_\phi H|S|K_V}{SN_{ch}} \qquad [14]$$

$$\Delta\omega_{VCO1} = \frac{-2\pi\beta|S|A_{OL}|S|\cdot N_{ch}\cdot\Delta f_{DEV}|S|}{1 + \beta|S|A_{OL}|S|} \qquad [15]$$

$$\frac{\Delta\omega_{VCO}|S|}{\Delta V\_TUNE|S|} = \Psi_{21}(S) = \frac{K_V}{1 + \frac{K_V H|S|K_\phi}{SN_{ch}}} \qquad [16]$$

$$\Delta\omega_{vco2} = \frac{2\pi K_0 K(S)ATT\cdot\Delta V_{DAC}(S)}{1 + \left[\frac{K_V H(S)K_\phi}{SN_{ch}}\right]} \qquad [17]$$

In order to achieve balance :

$$\Delta\omega_{vc02}(S)|_{S\,=\,jw\,=\,w_{UNITY}} = \Delta\omega_{VC\,01}(S)|_{S\,=\,jw_{UNITY}} \qquad [18]$$

Note at

$$W_{UNITY}\cdot|\beta(S)A_{OL}(S)|= 1$$

$$|-2\pi\cdot N_{ch}\cdot\Delta f_{dev}|\approx|2\pi K_0 K(S)ATT\cdot\Delta V_{DAC}(S)| \qquad [19]$$

$$ATT\cdot K_S = \frac{N_{ch}\cdot\Delta f_{dev\,max}}{K_0 V_{DAC\,Peak}} \qquad [20]$$

$$\mathrm{ATT\_dB} + \cdot K_s\_dB = 20\bullet\log 10\left(\frac{N_{ch}\cdot\Delta f_{dev\,max}}{K_0 V_{DAC\,Peak}}\right) \qquad [21]$$

The operation of the second port is illustrated in equation [9]. Noting that the VCO max deviation due to fractional deviation is +/- 67.708 kHz, it is possible to calculate the total desired attenuation using equation [21], which yields:

$$\mathrm{ATT\_dB} + K_s\_dB = 20\bullet\log10\left(\frac{67.708\cdot10^3}{25\cdot10^6\cdot0.4}\right) \cong -43.38\,\mathrm{dB} \qquad [22]$$

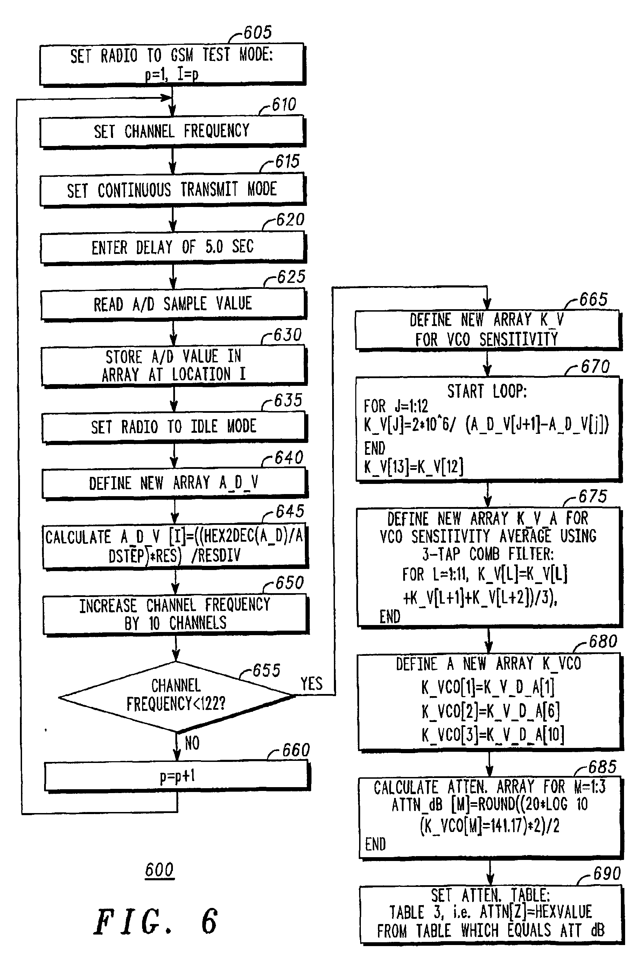

Referring now to FIG. 6, a flowchart 600 of the preferred dual-port modulator's attenuator tuning algorithm is illustrated. The flowchart commences in step 605 with the radio entering a GSM test mode. A counter 'p' is initialised to control the location of stored attenuator values for subsequent retrieval. A first channel frequency is then set, in step 610. The test mode then moves to a continuous transmit mode of operation with this channel frequency in step 615. A delay of, say, 0.5 seconds is introduced in step 620, as the group delay between the ports is not equal. The generated channel frequency is then sampled at step 625, and the sampled value stored in step 630 in an array (identified as A_D) at a location I.
The radio unit then enters an idle mode of operation in step 635. A new array (identified as A_D_V) is defined at step 640 and the attenuation values calculated for respective locations in the array at step 645, where:

$$A\_D\_V[I]=((HEX2DEC(A\_D)/ADSTEP)*RES)/RESDIV \qquad [29]$$

Where:

RES = A/D Resolution

RESDIV = A/D Resistor Voltage Ratio

ADSTEP = A/D No. of steps

This equation is used for estimating the sampled dual-port modulator voltage.

After calculating the attenuation value for this location, the channel frequency being sampled is increased, by say ten channels, as shown in step 650. If the channel frequency has not reached or exceeded the last frequency, say frequency no. '122' in step 655, the counter is increased in step 660. The process then repeats for this new channel frequency, from step 610, until the array is complete and the final channel frequency has been reached, in step 655.

At this stage, a new array for K_V is defined for VCO sensitivity, in step 665. A program loop is then commenced in step 670. A new array K_V_A for VCO sensitivity average using, say, a 3-tap comb filter is generated in step 675. A new array K_VCO is then defined in step 680. The attenuation values from the array are then calculated in step 685, for particular frequency ranges. The attenuation values are then stored as a table in a storage memory within the communication device, as shown in step 690. A typical table, i.e. a set of attenuation bits, according to the preferred embodiment of the present invention is illustrated in Table 4.

The algorithm supports a +/- 3.5dB mismatch, and therefore the attenuation bits related to say, an attenuation value of 6dB, 7dB and 8dB, are relevant.

Table 4:

| Attenuation bit values versus determined Attenuation value (dB) | | | | | |
|---|---|---|---|---|---|
| MOD_ATTEN BITS | | | | | ATTENUATION VALUE (dB) |
| 4 | 3 | 2 | 1 | 0 | |
| 0 | 1 | 0 | 1 | 1 | 10.0 |
| 0 | 1 | 1 | 0 | 0 | 9.5 |
| 0 | 1 | 1 | 0 | 1 | 9.0 |
| 0 | 1 | 1 | 1 | 0 | 8.5 |
| **0** | **1** | **1** | **1** | **1** | **8.0** |
| 1 | 0 | 0 | 0 | 0 | 7.5 |
| **1** | **0** | **0** | **0** | **1** | **7.0** |
| 1 | 0 | 0 | 1 | 0 | 6.5 |
| **1** | **0** | **0** | **1** | **1** | **6.0** |
| 1 | 0 | 1 | 0 | 0 | 5.5 |
| 1 | 0 | 1 | 0 | 1 | 5.0 |
| 1 | 0 | 1 | 1 | 0 | 4.5 |
| 1 | 0 | 1 | 1 | 1 | 4.0 |
| 1 | 1 | 0 | 0 | 0 | 3.5 |
| 1 | 1 | 0 | 0 | 1 | 3.0 |

In use, the radio channels are preferably divided into a number of sub-sections; for example, a GSM communication unit may be divided into, say, three sections. For example, Section 1: 890 MHz - 900 MHz, Section 2: 900 - 910 MHz, and Section 3: 910 - 914.8 MHz.

The level of attenuation determined by the algorithm will be translated into a set of attenuation bits for a particular channel or range of channels, e.g. a first attenuator value will be related to Section 1, a second attenuator to Section 2, etc. Thus, with knowledge of the transmitted channel, the desired ATT value can be selected and set. The algorithm will select the optimum attenuator at the desired sub-band. The technique is inexpensive and avoids tuning time at the factory. It is envisaged that the values should be stored in a code-plug (memory element) of the wireless communication unit, as known to those skilled in the art.

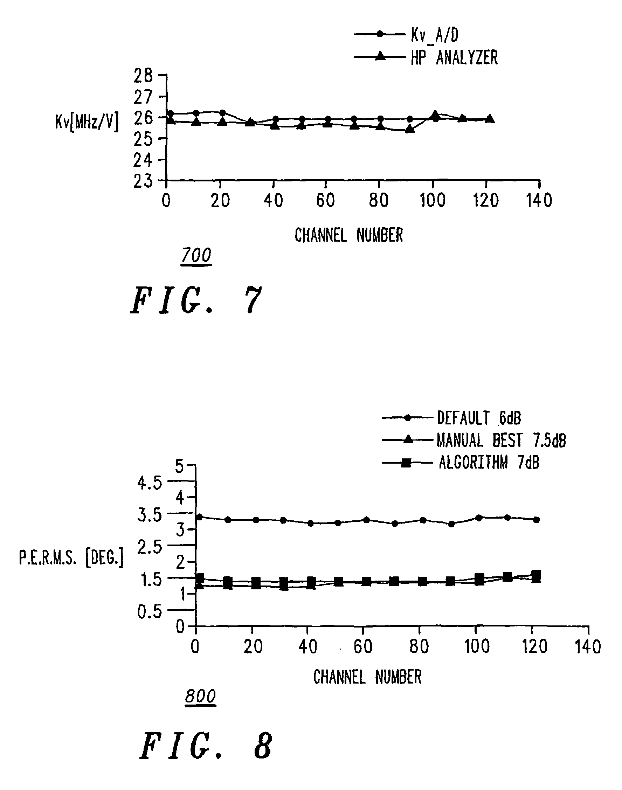

Referring now to FIG. 7 and FIG. 8, graphs 700, 800 of VCO sensitivity and phase error RMS are illustrated, highlighting the advantages of employing the algorithm of FIG. 6. FIG. 7 illustrates how well the actual VCO sensitivity tracks the estimated VCO sensitivity using the aforementioned tuning algorithm. As can be clearly seen, the actual and estimated VCO sensitivity performance of Kv varies by < 1 MHz/V across 120 channels. FIG. 8 illustrates how well the phase error RMS performs across these transmit channels when employing and without employing the attenuator-tuning algorithm. As can be clearly seen, the algorithm performs substantially as well as the optimal manual tuning of phase RMS at approximately <1.5 degrees, and substantially better than the default phase error RMS of 3 to 3.5 degrees.

Although the present invention has been described with reference to dual-port modulators, it is envisaged that the inventive concepts described are equally applicable to any signals that are synthesized using superposition, which need adjustments due to group delay, attenuation or frequency selectivity.

It will be understood that the attenuation tuning mechanism, as described above, provides singly or in combination at least some of the following advantages:

(i) Attenuation mismatch between the dual-port and direct port is minimised by employing the proposed algorithm.
(ii) Loop filter component and VCO sensitivity tolerances, affecting the dual-port mismatch, are no longer a critical factor. Hence, inexpensive reference oscillators, operating with less accuracy can be used.
(iii) The hardware and software implementation of the proposed algorithm is simple and results in an accurate determination of the attenuation to be used.
(iv) There is no requirement to set VCO attenuation levels to a specific value during factory set-up, using an algorithm that includes a series of phase error measurements. Hence, manufacturing time is significantly reduced.
(v) The need for calibration stations that are able to read phase error and/or spectral information can be eliminated.

Whilst specific, and preferred, implementations of the present invention are described above, it is clear that one skilled in the art could readily apply variations and modifications of such inventive concepts.

Thus a wireless communication unit, and a method for tuning a radio frequency signal in a wireless communication unit have been provided where the disadvantages described with reference to prior art arrangements have been substantially alleviated.

**Claims**

1. A wireless communication unit (400) comprising:

a dual-port modulator (406, 408) for generating a radio frequency signal to be used by the wireless communication unit;
a data generator (570), operably coupled to the dual-port modulator (406, 408), for generating data to be transmitted;
a digital to analogue converter (446), operably coupled to the data generator (570) for converting the digital data to an analogue signal to be used in generating the radio frequency signal; and
an attenuator (450), operably coupled to the digital to analogue converter (446) to attenuate the analogue signal output from the digital to analogue converter (446);

the wireless communication unit (400) **characterised by**:

a signal processor (402) operably coupled to the attenuator (450) for setting an attenuation value of the attenuator (450) to balance signals input to two ports of said dual-port modulator.

2. The wireless communication unit (400) according to claim 1, further **characterised by** said signal processor (402) storing one or more attenuation values for a frequency or range of frequencies of said radio frequency generation circuit (404), such that a set of attenuation values can be used to more accurately attenuate said analogue signal level output from said digital to analogue converter (446) dependent on the signal frequency generated by the wireless communication unit (400).

3. The wireless communication unit (400) according to Claim 1 or Claim 2, further **characterised by** said attenuation value selected by said processor being of a form:

$$\text{ATT\_dB} + \cdot K_s \_ dB = 20 \bullet \log 10 \left( \frac{N_{ch} \cdot \Delta f_{dev\,max}}{K_0 V_{DAC\,Peak}} \right)$$

4. The wireless communication unit (400) according to any preceding Claim 1 wherein said attenuation level is selected by said processor to counteract any port mismatch dependent upon a determined phase error RMS difference between said ports.

5. The wireless communication unit (400) according to any of the preceding Claims, wherein the wireless communication unit (400) is one of a portable or mobile (PMR) radio, a mobile phone, a personal digital assistant, a wireless capable laptop computer.

6. A method of tuning (600) a dual-port modulator of a radio frequency signal in a wireless communication unit, the method **characterised by** the following steps:

generating a channel frequency;
sampling (625) the generated channel frequency;
storing (630) a sampled value of the generated channel frequency in an array;
adjusting (655) a channel frequency being sampled;
repeating the steps of generating, sampling (625), storing (630) and adjusting (655), until selected channel frequencies have been sampled;
calculating (685) attenuation values from the sampled values stored in the array(s); and
controlling a signal level of a digital to analogue converter output to balance signals input to two ports of said dual-port modulator.

7. The method of tuning (600) a dual-port modulator according to Claim 6, wherein the step of controlling is performed to balance a phase error RMS imbalance between said two ports of said dual-port modulator.

8. The method of tuning (600) a dual-port modulator according to Claim 6 or Claim 7, wherein said steps of calculating and controlling are performed for particular frequency ranges of said wireless communication unit.

9. The method of tuning (600) a dual-port modulator according to any of preceding Claims 6 to 8, the method further **characterised by** the step of:

introducing (620) a delay before said step of sampling to compensate for a group delay between said two ports of said dual-port modulator.

10. A wireless communication unit (400) according to any of preceding Claims 1 to 5, or a method of tuning (600) a dual-port modulator according to any of preceding Claims 6 to 9, applied to a mobile phone capable of operating in the global system for mobile communications system.

11. A storage medium storing processor-implementable instructions for controlling a processor to carry out the method of any of Claims 6 to 9.

100

RECEIVED DUAL-PORT CONSTELLATION

110

RECEIVED DUAL-PORT CONSTELLATION

INTERNAL ATTENUATION = 6dB
VCO SENSITIVITY = 24 MHz/V
PHASE ERROR RMS = 1.089 DEG.
PHASE ERROR PEAK = 3.219 DEG.
PHASE DETECTOR PHASE NOISE = -98 dBc/Hz
ESTIMATED DUAL PORT MISMATCH = 0.23 dB
DIRECT PORT CLOSE LOOP B/W = 99 KHz
PHASE MARGIN = 52 DEG.

INTERNAL ATTENUATION = 6dB
VCO SENSITIVITY = 24 MHz/V
PHASE ERROR RMS = 3.32 DEG.
PHASE ERROR PEAK = 6.25 DEG.
PHASE DETECTOR PHASE NOISE = -98 dBc/Hz
ESTIMATED DUAL PORT MISMATCH = 1.5 dB
DIRECT PORT CLOSE LOOP B/W = 99 KHz
PHASE MARGIN = 52 DEG.

*FIG. 1*

200

*FIG. 2*

300

*FIG. 3*

FIG. 4

400

*FIG. 5*

*600*

*FIG. 6*

Flowchart 600:

605 — SET RADIO TO GSM TEST MODE: p=1, I=p

610 — SET CHANNEL FREQUENCY

615 — SET CONTINUOUS TRANSMIT MODE

620 — ENTER DELAY OF 5.0 SEC

625 — READ A/D SAMPLE VALUE

630 — STORE A/D VALUE IN ARRAY AT LOCATION I

635 — SET RADIO TO IDLE MODE

640 — DEFINE NEW ARRAY A_D_V

645 — CALCULATE A_D_V [I]=((HEX2DEC(A_D)/A DSTEP)*RES) /RESDIV

650 — INCREASE CHANNEL FREQUENCY BY 10 CHANNELS

655 — CHANNEL FREQUENCY<122? YES / NO

660 — p=p+1

665 — DEFINE NEW ARRAY K_V FOR VCO SENSITIVITY

670 — START LOOP:
FOR J=1:12
K_V[J]=2*10^6/ (A_D_V[J+1]−A_D_V[j])
END
K_V[13]=K_V[12]

675 — DEFINE NEW ARRAY K_V_A FOR VCO SENSITIVITY AVERAGE USING 3-TAP COMB FILTER:
FOR L=1:11, K_V[L]=K_V[L] +K_V[L+1]+K_V[L+2])/3),
END

680 — DEFINE A NEW ARRAY K_VCO
K_VCO[1]=K_V_D_A[1]
K_VCO[2]=K_V_D_A[6]
K_VCO[3]=K_V_D_A[10]

685 — CALCULATE ATTEN. ARRAY FOR M=1:3
ATTN_dB [M]=ROUND((20*LOG 10 (K_VCO[M]=141.17)*2)/2
END

690 — SET ATTEN. TABLE:
TABLE 3, i.e. ATTN[Z]=HEXVALUE FROM TABLE WHICH EQUALS ATT dB

700

# FIG. 7

800

# FIG. 8